Europäisches Patentamt

European Patent Office

Office européen des brevets

(19)

(11) Veröffentlichungsnummer: **0 013 025**

**A1**

(12) **EUROPÄISCHE PATENTANMELDUNG**

(21) Anmeldenummer: **79105361.4**

(22) Anmeldetag: **24.12.79**

(51) Int. Cl.³: **G 01 R 21/00**
**G 01 J 1/46**

(30) Priorität: **29.12.78 DE 2856637**

(43) Veröffentlichungstag der Anmeldung:
**09.07.80 Patentblatt 80/14**

(84) Benannte Vertragsstaaten:
**FR GB NL**

(71) Anmelder: **Kernforschungsanlage Jülich Gesellschaft mit beschränkter Haftung**
**Postfach 1913**
**D-5170 Jülich(DE)**

(72) Erfinder: **Herwig, Labus, Dr.**
**Petternicher Strasse 9a**
**D-5170 Jülich(DE)**

(72) Erfinder: **Nellen, Robert**
**Carl-Alexander-Strasse 75**
**D-5112 Baesweiler(DE)**

(74) Vertreter: **Schrumpf, Frithjof, Dipl.-Chem. et al,**
**Koenenstrasse 20 Postfach 731**
**D-5160 Düren(DE)**

(54) **Langzeitintegrator für eine Spannungsquelle kleiner Spannung.**

(57) Bei einem Langzeitintegrator für eine Spannungsquelle kleiner Spannung ist die Spannungsquelle mit dem Eingang eines monolithischen Dual-Slope-Integrators verbunden, bei welchem an den die Oszillatorimpulse führenden Ausgang ein elektronischer Untersetzer mit nachgeschaltetem mechanischem Zählwerk angeschlossen ist und eine den elektronischen Untersetzer auftastende Torschaltung an einen Ausgang des Dual-Slope-Integrators derart angeschlossen ist, daß jeweils während der Integrationsperiode ein Auftastsignal abgegeben wird.

EP 0 013 025 A1

./...

0013025

21.12.1979
K 278

Anmelderin:
Kernforschungsanlage Jülich GmbH
D-5170 Jülich


Langzeitintegrator für eine Spannungsquelle
kleiner Spannung


Beschreibung

Die Erfindung betrifft einen Langzeitintegrator für eine Spannungsquelle kleiner Spannung.

Anwendungsgebiet der Erfindung ist die Integration der Solarstrahlung. Für die Bewertung von Solaranlagen mußt die globale Sonneneinstrahlung in ($kW/m^2$) über lange Zeiträume ($>1$ Jahr) aufintegriert werden. Hierzu wird die Strahlungsintensität in einem Solarimeter in proportionale Spannungen von $<0,01$ mV bis $>10,0$ mV umgesetzt. Eine elektronischer Langzeitintegrator bildet hieraus ein Spannungs-Zeit-Produkt, welches digital angezeigt und in ($kWh/m^2$) geeicht werden muß. Derartige

- 2 -

Langzeitintegratoren müssen in erster Linie zuverlässig und preiswert sein.

Bekannte Langzeitintegratoren bestehen aus Spannungs-Frequenz-Wandler mit nachgeschalteten Untersetzern und mechanischen Zählwerken. Es gibt preiswerte monolithisch integrierte Spannungs-Frequenz-Wandler (z.B. Teledyne 9400). Ihre Eingangsempfindlichkeit und Offsetstabilität reicht jedoch für den direkten Anschluß von Solarimetern nicht aus, so daß dem Spannungs-Frequenz-Wandler ein Verstärker vorgeschaltet werden muß. Dieser Verstärker verursacht erhebliche Kosten. Er benötigt stabile Beschaltungselemente, einen Offset-Kompensations-Trimmer und sehr niedrigen Temperaturkoeffizienten der Offsetdrift von $< 2,0 \ \mu V/^{o}C$.

Aufgabe der Erfindung ist die Bereitstellung eines Langzeitintegrators, der eine zeitlich gleichbleibende Empfindlichkeit besitzt und ohne analoge Vorverstärkung arbeiten kann.

Zur Lösung dieser Aufgabe sieht die Erfindung vor, daß die Spannungsquelle mit dem Eingang eines monolithischen Dual-Slope-Integrators verbunden ist, daß an den die Oszillatorimpulse führenden Ausgang ein elektronischer Untersetzer mit nachgeschaltetem mechanischem Zählwerk angeschlossen ist und daß eine den elektronischen Untersetzer auftastende Torschaltung an einen Ausgang des Dual-Slope-Integrators derart angeschlossen ist, daß jeweils während der Integrationsperiode der Bezugsspannung ein Auftastsignal abgegeben wird.

Die Verwendung eines Dual-Slope-Integrators erlaubt eine direkte Messung einer kleinen analogen Eingangsspannung. Die beanspruchte Schaltung ermöglicht eine Langzeitintegration der Messimpulse. Damit ist es möglich mit hoher und gleichbleibender Langzeitempfindlichkeit kleine Spannungen zu integrieren. Die Erfindung ermöglicht damit die Bestimmung der Solarstrahlung über lange Zeiträume von einem Jahr und mehr.

In weiterer Ausbildung schlägt die Erfindung vor,

- 3 -

daß der Trennverstärkerausgang des Dual-Slope-Integrators an eine Differentiationsstufe angeschlossen ist und daß die die Differentiationssignale führende Leitung eine als Torschaltung dienende bistabile RS-Kippstufe steuert. Durch diese Ausgestaltung der Erfindung wird aus der Trennverstärkerausgangsspannung eine Schaltimpulsfolge für den elektronischen Untersetzer abgeleitet, da der Dual-Slope-Integrator normalerweise kein logisches Ausgangssignal während der Zählperiode für die Bezugsspannung bereitstellt.

Damit das differentiierte Ausgangssignal des Trennverstärkers eine sichere Tastung des Untersetzers ermöglicht, sieht die Erfindung vor, daß an die Differentiationsstufe eine Operationsverstärkereinheit angeschlossen ist.

Zur Erhöhung der Stabilität und Konstanthaltung der Empfindlichkeit sieht die Erfindung vor, daß der Dual-Slope-Integrator eine automatische Offset-Kompensation aufweist. Es kann z.B. ein monolithischer Dual-Slope-Integrator der Bautype ICL 7107 der Firma Intersil eingesetzt werden.

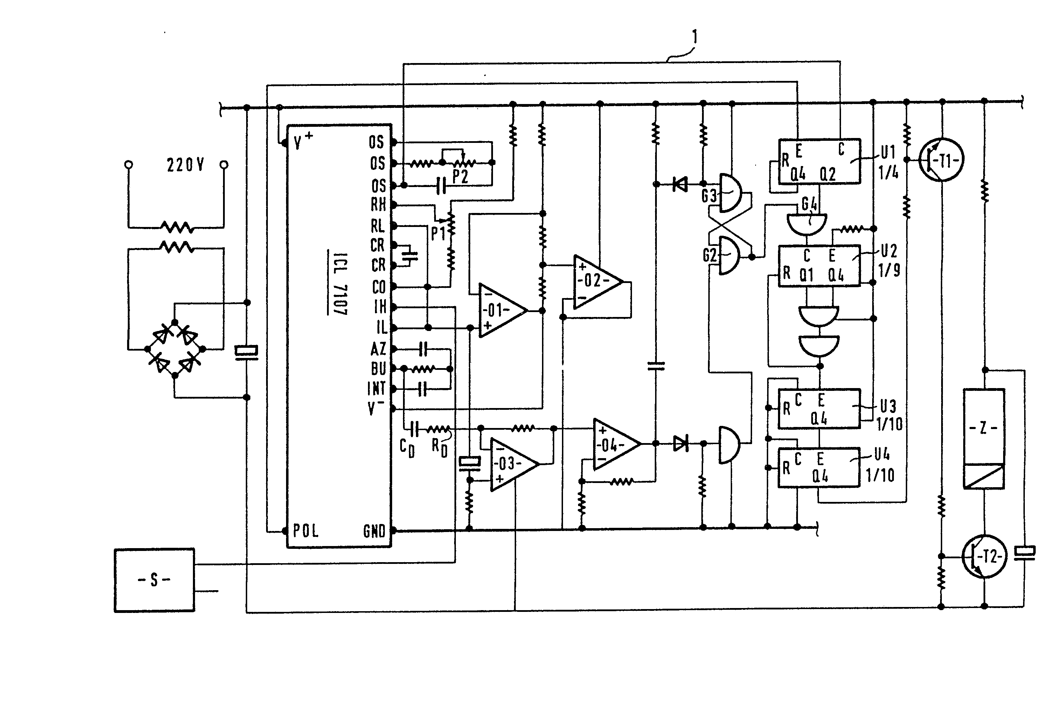

In der Figur ist die Schaltung einer Ausführungsform der Erfindung dargestellt. Man erkennt den monolithischen Dual-Slope-Integrator der Bautype ICL 7107 mit den Anschlußverbindungen. Der Oszillator des Integrators wird mit Hilfe des Potentiometer P2 in seiner Frequenz eingestellt und kann auf 4,00 kHz getrimmt werden. Die Oszillatorimpulse liegen über eine Leitung 1 an einem elektronischen Untersetzer mit den Untersetzerstufen U1, U2, U3, U4 an, die jeweils ein Untersetzungsverhältnis 1/4, 1/9, 1/10, 1/10 haben, so daß sich eine Gesamtuntersetzung von 1/3600 ergibt. Der Ausgang der Untersetzerstufe U4 ist über eine Verstärkerstufe mit den Transistoren T1 und T2 an ein mechanisches Zählwerk fest angeschlossen, das die Impulse zählt und anzeigt. Die Bezugsspannung des Dual-Slope-Integrators kann mit

- 4 -

Hilfe des Potentiometers P1 eingestellt werden und wird über den Anschluß RH dem monolithischen Schaltkreis zugeführt. Die Bezugsspannung kann in einem Meßbereich von circa 6,0 bis 19,0 mV eingestellt werden.

Die Operationsverstärker 01 und 02 (je 1/4 LM348D) erzeugen mit minimalem Aufwand aus der internen Bezugsspannung des Dual-Slope-Integrators die Versorgungsspannungen.

Da der Dual-Slope-Integrator während der Integrationsdauer der Bezugsspannung kein logisches Signal abgibt, muß dieses durch externe Schaltkreise abgeleitet werden. Dieses geschieht durch Differentiation des am Ausgang BU anliegenden Trennverstärkerausgangssignals. Die Differentiation erfolgt mit Hilfe des Kondensators $C_D$ und des Widerstandes $R_D$. Die Differentiationsimpulse werden in den Operationsverstärkern 03 und 04 ( je 1/4 LM348D) verstärkt. Die verstärkten Nadelimpulse steuern die bistabile RS-Kippstufe G2, G3, ( je 1/4 SN74C00) an. Die Nadelimpulse bewirken in der aus dem Schaltbild ersichtlichen Weise eine Einschaltung und Rückschaltung dieser bistabilen Kippstufe. Das Ausgangssignal dieser bistabilen Kippstufe tastet über eine UND-Schaltung G4 den elektronischen Untersetzer, so daß derselbe jeweils in Abhängigkeit von Änderungen des Trennverstärkerausgangssignales während der Integrationsperioden der Bezugsspannung die Oszillatorimpulse zählt. Die Polarität der Differentiationsimpulse sorgt im Hinblick auf die Anschaltung an die RS-Kippstufe für eine richtige Zählung.

Die Operationsverstärker 03 und 04 ermöglichen eine hohe Verstärkung des Trennverstärkerausgangssignales mit einem Verstärkungsfaktor von mehr als 1000, ohne daß Instabilitäten oder Störungen auftreten.

Ein Solarimeter S ist mit seinem Meßspannungsausgang an den Eingang IH des Dual-Slope-Integrators angeschlossen.

Die angegebene Schaltung mit der gewählten Untersetzung ermöglicht eine besonders vorteilhafte Eichmöglichkeit des Gerätes. Für jedes Solarimeter wird vom
Hersteller die einer Strahlungsintensität von 1 kWh/m$^2$
entsprechende Ausgangsspannung angegeben. Wenn man die
Bezugsspannung am Potentiometer P2 dieser Solarimeterausgangsspannung gleich macht, so zählt der mechanische
Zähler bei der angegebenen Untersetzung genau 1000
Pulse pro kWh/m$^2$.

21.12.1979
K 278

Anmelderin:

Kernforschungsanlage Jülich GmbH
D-5170 Jülich

Patentansprüche

1. Langzeitintegrator für eine Spannungsquelle kleiner Spannung, dadurch gekennzeichnet, daß die Spannungsquelle (S) mit dem Eingang (IH) eines monolithischen Dual-Slope-Integrators verbunden, daß an den die Oszillatorimpulse führenden Ausgang (OS) ein elektronischer Untersetzer mit nachgeschaltetem mechanischem Zählwerk (Z) angeschlossen ist und eine den elektronischen Untersetzer auftastende Torschaltung (G2, G3) an einen Ausgang des Dual-Slope-Integrators derart angeschlossen ist, daß jeweils während der Integrationsperiode der Bezugsspannung ein Auftastsignal abgegeben wird.

2. Langzeitintegrator nach Anspruch 1, dadurch gekennzeichnet, daß der Trennverstärkerausgang (BU) des Dual-Slope-Integrators an eine Differentiationsstufe ($C_D$, $R_D$) angeschlossen ist und daß die die Differentiationssignale führende Leitung eine als Torschaltung dienende bistabile RS-Kippstufe (G2,G3) steuert.

3. Langzeitintegrator nach Anspruch 2, dadurch gekennzeichnet, daß an die Differentiationsstufe ($C_D$, $R_D$) eine Operationsverstärkereinheit (03, 04) angeschlossen ist.

4. Langzeitintegrator nach einem der Ansprüche 1 bis 3, dadurch gekennzeichnet, daß der Dual-Slope-Integrator eine automatische Offset-Kompensation aufweist.

Europäisches
Patentamt

**EUROPÄISCHER RECHERCHENBERICHT**

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| | <u>US - A - 3 818 340</u> (KEIKI YAMAGUCHI)<br><br>x Zusammenfassung; Spalte 1, Zeile 25 bis Spalte 5, Zeile 2; Spalte 6, Zeile 23 bis Spalte 7, Zeile 4; Abbildungen 1-3 x<br><br>-- | 1 | G 01 R 21/00<br>G 01 J 1/46 |
| | <u>DE - A - 2 438 212</u> (SIEMENS)<br><br>x Seite 6, Anspruch 1; Seite 7, Anspruch 6 x<br><br>-- | 1 | |
| | INSTRUMENTS AND EXPERIMENTAL TECHNIQUES, Nr. 6, November/ Dezember 1966, New York, US, VEISMANN: "Electronic digital voltmeter as a voltage integrator", Seiten 1486-1487<br><br>x Seite 1486, Zeilen 1-14 x<br><br>---- | 1 | **RECHERCHIERTE SACHGEBIETE (Int. Cl. 3)**<br><br>G 01 R 21/00<br>G 06 J 1/00<br>H 03 K 13/20<br>G 01 J 1/46 |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt

| Recherchenort | Abschlußdatum der Recherche | Prüfer |
|---|---|---|
| Den Haag | 13-03-1980 | GUIVOL |

EPA form 1503.1 06.78